Europäisches Patentamt

European Patent Office

Office européen des brevets

(11) Veröffentlichungsnummer : **0 018 571**
**B1**

(12) **EUROPÄISCHE PATENTSCHRIFT**

(45) Veröffentlichungstag der Patentschrift :
26.01.83

(51) Int. Cl.³ : **H 03 F   3/62**, H 03 F   3/19

(21) Anmeldenummer : **80102139.5**

(22) Anmeldetag : **21.04.80**

(54) Wechselspannungsverstärkerschaltung mit mehreren in Gate-(Basis-)Schaltung betriebenen Halbleiterverstärkerelementen.

(30) Priorität : **27.04.79 DE 2917275**

(43) Veröffentlichungstag der Anmeldung :
**12.11.80 Patentblatt 80/23**

(45) Bekanntmachung des Hinweises auf die Patenterteilung : **26.01.83 Patentblatt 83/04**

(84) Benannte Vertragsstaaten :
**BE FR GB IT NL**

(56) Entgegenhaltungen :
**DE A 2 646 035**
**GB A 1 310 500**

(73) Patentinhaber : **SIEMENS AKTIENGESELLSCHAFT**
**Berlin und München Wittelsbacherplatz 2**
**D-8000 München 2 (DE)**

(72) Erfinder : **Ritter, Gerhard, Dipl.-Ing.**
**Mühlweg 1**
**D-8911 Thaining (DE)**

## Wechselspannungsverstärkerschaltung mit mehreren in Gate-(Basis-)Schaltung betriebenen Halbleiterverstärkerelementen

Bei symmetrisch aufgebauten Halbleiterelementen, z.B. symmetrisch dotierten Transistoren oder Feldeffekttransistoren, erhalten deren äußere Elektroden ihre Bedeutung als Emitter und Collektor bzw. Source und Drain erst durch das Anlegen entsprechender Betriebsspannungen. Betreibt man derartige Halbleiterverstärkerelemente in Basis- bzw. Gate-Schaltung, so läßt sich durch Umschalten der Betriebsspannungen auch die Verstärkungsrichtung des Halbleiterverstärkerelements umschalten. Dabei ergeben sich in der Regel zum einen daraus, daß der jeweilige Eingangswiderstand des Halbleiterverstärkerelements relativ niedrig, der jeweilige Ausgangswiderstand dagegen relativ hoch ist, Anpassungsprobleme insbesondere dann, wenn ein den Halbleiterverstärker auf der einen (bzw. anderen) Seite abschließender Widerstand, der je nach der Betriebsrichtung des Halbleiterverstärkers den Quellen- oder den Lastwiderstand darstellt, einmal an den relativ niedrigen Eingangswiderstand des Halbleiterverstärkerelements und das andere Mal an dessen relativ hohen Ausgangswiderstand angepaßt sein müßte ; zum anderen ergeben sich Probleme u.a. des Leistungsverbrauchs im Zusammenhang mit unterschiedlichen Verstärkungsanforderungen insbesondere dann, wenn der Halbleiterverstärker in der einen Verstärkungsrichtung als Eingangsverstärker für relativ kleine Signalpegel, in der anderen Verstärkungsrichtung als Ausgangsverstärker, d.h. als Leistungsverstärker, wirken soll. Solche Probleme können insbesondere dann gegeben sein, wenn es sich um das erste bzw. letzte Glied einer ganzen Kette von in der Verstärkungsrichtung umschaltbaren Halbleiterverstärkerelementen handelt, wie sie z.B. aus der DE-OS 26 46 035 bekannt ist.

Für eine Anpassung an ein und denselben Widerstand für beide Verstärkungsrichtungen ist es aus der DE-OS 26 46 035 für eine Wechselspannungsschaltung mit mehreren in Basis-(Gate-)Schaltung betriebenen Halbleiterverstärkerelementen, deren Verstärkungsrichtung jeweils erst durch das Anlegen von bestimmten Spannungen festgelegt und damit durch Änderung dieser Spannungen umschaltbar ist, bekannt, für die Emitterelektrode (Source) und für die Kollektorelektrode (Drain) der einzelnen in Basis-(Gate-)Schaltung betriebenen Halbleiterverstärkerelemente eine Betriebsgleichspannungszuführung vorzusehen, die untereinander umschaltbar ausgebildet ist, und die Halbleiterverstärkerelemente stufenartig unter Zwischenschaltung von jeweils einem Vierpol-Netzwerk mit Bandpaßcharakter, das für beide Verstärkungsrichtungen den jeweiligen Ausgangswiderstand einer Stufe in den Eingangswiderstand der betriebsrichtungsmäßig nachfolgenden Stufe transformiert, in Kette zu schalten und dabei im transformierenden Vierpol-Netzwerk schaltbare Bauelemente zu verwenden, wobei bei der Umschaltung der Verstärkungsrichtung ebenfalls umzuschaltende Halbleiterdioden zur Umschaltung dieser Bauelemente verwendet werden können.

Die Erfindung zeigt demgegenüber einen Weg, einerseits grundsätzlich ohne solche schaltbaren Bauelemente in einem dem eigentlichen Halbleiterverstärker vor- bzw. nachgeschalteten transformierenden Vierpol-Netzwerk auszukommen und dennoch eine erwünschte Anpassung des Eingangswiderstandes bzw. des Ausgangswiderstandes des in seiner Verstärkungsrichtung umschaltbaren Halbleiterverstärkers an dessen Signalquelle bzw. Last bei Identität bzw. Gleichheit von Quelle- und Last-Widerstand zu ermöglichen und andererseits einen unnötig hohen Leistungsverbrauch zu vermeiden.

Die Erfindung betrifft eine Wechselspannungsverstärkerschaltung mit mehreren in Gate-(Basis-)Schaltung betriebenen Halbleiterverstärkerelementen, insbesondere Feldeffekttransistoren, deren Verstärkungsrichtung jeweils erst durch das Anlegen von bestimmten Betriebsspannungen festgelegt und durch Umschalten dieser Betriebsspannungen umschaltbar ist ; eine solche Wechselspannungsverstärkerschaltung ist erfindungsgemäß dadurch gekennzeichnet, daß wenigstens zwei Halbleiterverstärkerelemente parallel zueinander vorgesehen sind, von denen ein symmetrisch aufgebautes Halbleiterverstärkerelement sowohl bei Betrieb der Wechselspannungssverstärkerschaltung als Kleinsignalverstärker in der einen Verstärkungsrichtung als auch bei Betrieb der Wechselspannungsverstärkerschaltung als Leistungsverstärker in der anderen Verstärkungsrichtung wirksam ist, während das (die) weitere(n) Halbleiterverstärkerelement(e) bei Umschaltung der Verstärkungsrichtung für die Leistungsverstärkung zu- bzw. in Gegenrichtung für die Kleinsignalverstärkung abschaltbar ist (sind).

Die Erfindung, die insbesondere in der Ausgangs-/Eingangsstufe einer Kette von Halbleiterverstärkern mit umschaltbarer Verstärkungsrichtung Anwendung finden kann, bringt den Vorteil mit sich, zumindest angenähert gleiche Betriebswiderstände der Wechselspannungsverstärkerschaltung in beiden Verstärkungsrichtungen erzielen zu können und zugleich bei Betrieb der Wechselspannungsverstärkerschaltung als Eingangsverstärker mit einem Halbleiterverstärkerelement wesentlich kleinerer Steilheit auskommen zu können, als dies bei Betrieb der Wechselspannungsverstärkerschaltung als Leistungsverstärker der Fall ist, womit im ersteren Betriebsfall zugleich der Leistungsverbrauch entsprechend herabgesetzt ist.

In weiterer Ausgestaltung der Erfindung kann sowohl das genannte eine Halbleiterverstärkerelement als auch jedes weitere Halbleiterverstärkerelement einen Feldeffekttransistor aufweisen. Zweckmäßig ist es aber auch, daß gemäß weiterer Ausgestaltung der Erfindung das genannte eine Halbleiterverstärkerelement einen Feldeffekttransistor, jedes genannte weitere Halbleiterverstärkerelement dagegen einen bipolaren Transistor aufweist. Ein solcher bipolarer Transistor, der bei stark unterschiedlichen Dotierungen von Kollektor- und Emitterzone für eine Umschaltung seiner Verstärkungsrichtung weniger geeignet wäre, gestattet heute größere Ausgangsleistungen als Feldeffekttransistoren und erscheint insofern als zu- und abschaltbares, nur in der einen Verstärkungsrichtung wirksames Leistungs-Verstärkungselement als besonders vorteilhaft.

Weitere Einzelheiten der Erfindung werden anhand der Zeichnung näher erläutert. Dabei zeigt

Figur 1 ein Ausführungsbeispiel einer Wechselspannungsverstärkerschaltung gemäß der Erfindung mit zwei durch Feldeffekttransistoren gegebenen Halbleiterverstärkerelementen ;

Figur 1a deutet die Realisierung eines der Halbleiterverstärkerelemente durch einen bipolaren Transistor an.

Figur 2 zeigt eine entsprechende Wechselspannungsverstärkerschaltung, die in ihren beiden Parallelzweigen getrennte Anpassungsvierpole enthält, und

Figur 3 zeigt eine entsprechende Wechselspannungsverstärkerschaltung, bei der die beiden Parallelzweige über einen Diplexer zusammengeschaltet sind.

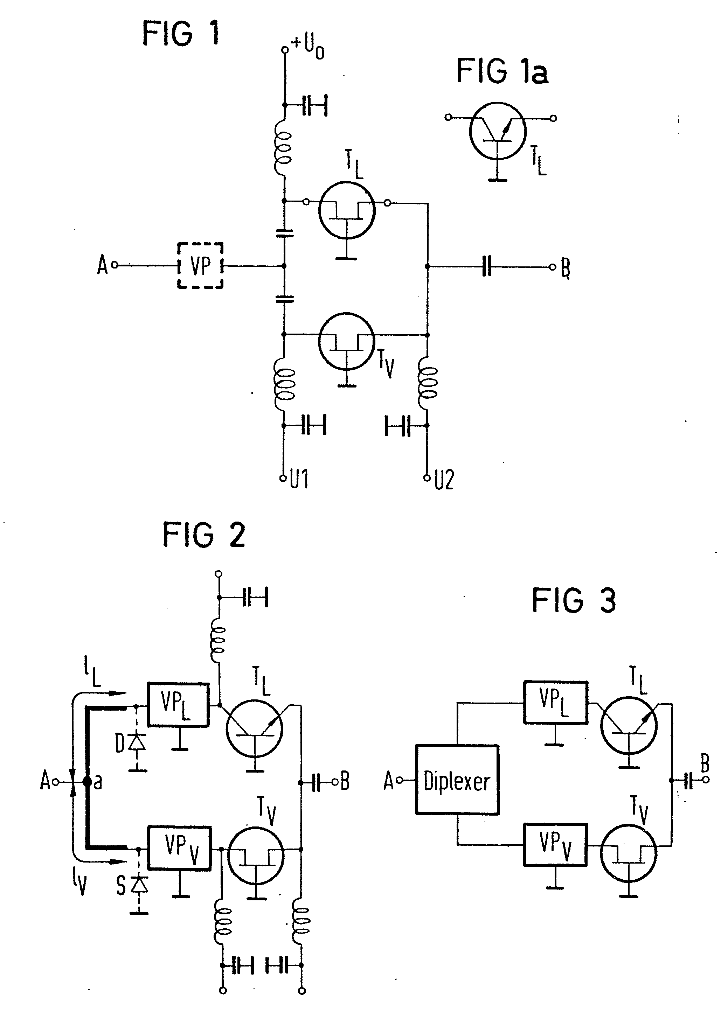

Die Zeichnung Fig. 1 zeigt eine insbesondere als Ausgangs-/Eingangsstufe einer z.B. aus der DE-OS 26 46 035 bekannten Kette von in der Verstärkungsrichtung umschaltbaren Halbleiterverstärkerelementen einzusetzende Halbleiterverstärkerschaltung gemäß der Erfindung, in der zwei beispielsweise durch zwei Feldeffekttransistoren gegebene und dabei ggf. auf einem Chip integrierte oder in einer Hybridschaltung in einem gemeinsamen Gehäuse zusammengefaßte Halbleiterverstärkerelemente $T_V$, $T_L$ parallel zueinander vorgesehen sind. Diese Verstärkerschaltung liegt zwischen zwei Anschlüssen A und B, von denen der Anschluß A den Ausgang/Eingang einer solchen Kette von in der Verstärkungsrichtung umschaltbaren Halbleiterverstärkerelementen bilden mag, wobei dann der Anschluß B mit dem nächsten Glied einer solchen Verstärkerkette verbindet.

Eine solche Endstufe einer in der Verstärkungsrichtung umschaltbaren Verstärkerkette soll zum einen bei Betrieb als Ausgangsstufe eine entsprechende Leistung abgeben ; zum anderen braucht sie bei Betrieb als Eingangsstufe nur kleine Signalpegel zu verarbeiten. Bei der Verwendung von Feldeffekttransistoren . bedeutet dies, daß für den Leistungsverstärkerbetrieb eine relativ große Kanalweite erforderlich ist, während bei Eingangsverstärkerbetrieb eine relativ kleine Kanalweite zweckmäßig ist. Betrachtet man dazu die für eine Anpassung notwendigen Anschlußwiderstände, so ergibt sich bei Leistungsverstärkerbetrieb für den Lastwidersand $R_L$ näherungsweise $R_L \simeq U_o^2/2P$, worin Uo die Betriebsspannung und P die abgegebene Signalleistung bedeuten ; bei Eingangsverstärkerbetrieb ergibt sich für den Quellenwiderstand $R_Q$ näherungsweise $R_Q \simeq 1/S$, worin S die Steilheit des Halbleiterverstärkerelements bedeutet. Bei vorgegebener Signalleistung P und damit vorgegebener erforderlicher Kanalweite des Feldeffekttransistors bei Leistungsverstärkerbetrieb läßt sich eine zugehörige Kanalweite des Feldeffekttransistors für dessen Betrieb als Eingangsverstärker finden, bei der die beiden Widerstände $R_L$ und $R_Q$ gleich sind.

Hierzu sieht nun die Erfindung vor, daß bei der Umschaltung der Verstärkungsrichtung gewissermaßen das Maß an tatsächlich verfügbarer Kanalweite, das bei Leistungsverstärkerbetrieb zusätzlich benötigt wird, zugeschaltet bzw. bei Eingangsverstärkerbetrieb als nicht benötigt abgeschaltet wird, indem von den parallel zueinander vorgesehenen zwei Halbleiterverstärkerelementen $T_V$, $T_L$ das eine Halbleiterverstärkerelement $T_V$ sowohl bei Betrieb der in Fig. 1 dargestellten Wechselspannungsverstärkerschaltung als Eingangsverstärker in der einen Verstärkungsrichtung, nämlich in der Verstärkungsrichtung A-B, als auch bei Betrieb der Wechselspannungsverstärkerschaltung als Leistungsverstärker in der anderen Verstärkungsrichtung B-A wirksam ist, während das weitere Halbleiterverstärkerelement $T_L$ bei Umschaltung der Verstärkungsrichtung zu- bzw. abschaltbar ist. Dies wird in der Wechselspannungsverstärkerschaltung nach Fig. 1 durch den Halbleiterverstärkerelementen $T_V$, $T$, zugeführte unterschiedliche Betriebsspannungen U1 und U2 erreicht :

Ist die jeweils der dem Anschluß A zugewandten Elektrode zugeführte Betriebsspannung U1 positiv und die jeweils der dem Anschluß B zugewandten Elektrode zugeführte Betriebsspannung U2 negativ, so arbeitet die Wechselspannungsverstärkerschaltung nach Fig. 1 als Leistungsverstärker in Richtung B-A, wobei der Feldeffekttransistor $T_L$ den Hauptteil der Leistung liefert. Der Feldeffekttransistor $T_L$ kann dazu seinerseits als Parallelschaltung von beispielsweise vier Feldeffekttransistoren realisiert sein, ohne daß dies in Fig. 1 im einzelnen näher dargestellt wäre.

Ist umgekehrt die Betriebsspannung U1 negativ und die Betriebsspannung U2 positiv, so wird der Feldeffekttransistor $T_L$ gesperrt, und der Feldeffekttransistor $T_V$ arbeitet jetzt allein als Eingangsverstärker in der Verstärkungsrichtung A-B.

Während das eine Halbleiterverstärkerelement $T_V$ der Schaltungsanordnung nach Fig. 1 so in beiden Verstärkungsrichtungen betrieben werden kann, wird das weitere Halbleiterverstärkerelement $T_L$ nur in einer Verstärkungsrichtung betrieben und hierzu beim Übergang auf diese Verstärkungsrichtung zugeschaltet und beim Wechsel auf die andere Verstärkungsrichtung wieder abgeschaltet. Dabei kann das genannte weitere Halbleiterverstärkerelement $T_L$

der Schaltungsanordnung nach Fig. 1 auch durch einen bipolaren Transistor gebildet sein, wie dies in Fig. 1a angedeutet ist, bzw. durch eine Parallelschaltung einer Mehrzahl von bipolaren Transistoren, was in der Zeichnung nicht weiter dargestellt ist. Solche bipolare Transistoren sind insbesondere dann von Vorteil, wenn die mit ihnen erzielbaren Ausgangsleistungen höher sind als die Ausgangsleistungen von Feldeffekttransistoren. Für ein abwechselnd in beiden Verstärkungsrichtungen zu betreibendes Halbleiterverstärkerelement $T_V$ wird dagegen die Realisierung durch einen Feldeffekttransistor wegen dessen besserer Symmetrieeigenschaften vorzuziehen sein.

Es wurde bereits darauf hingewiesen, daß in der Schaltungsanordnung nach Fig. 1 das genannte weitere, bei der Umschaltung der Verstärkungsrichtung zu- bzw. abschaltbare Halbleiterverstärkerelement $T_L$ durch die Parallelschaltung einer Mehrzahl solcher weiterer Halbleiterverstärkelemente realisiert sein kann. Des weiteren kann (können) auch das (die) weitere(n) Halbleiterverstärkerelement(e) $T_L$ mit weiteren solchen Halbleiterverstärkerelementen zu einem mehrstufigen Verstärker verbunden sein, ohne daß dies in Fig. 1 näher ausgeführt wäre. Dabei kann es sich beispielsweise um einen mit handelsüblichen Kleinsignal-Silizium-Feldeffekttransistoren aufgebauten dreistufigen Verstärker handeln, in dessen einzelnen Stufen die Halbleiterverstärkerelemente $T_L$ jeweils durch eine Parallelschaltung von vier Feldeffekttransistoren realisiert sein können ; in einem solchen beispielsweise 300-MHZ Signale verarbeitenden Verstärker können dann eine Verstärkung von beispielsweise 30 dB und eine Ausgangsleistung von beispielsweise 100 mW erreichbar sein.

In der Zeichnung Fig. 1 ist noch angedeutet, daß bei der dargestellten Wechselspannungsverstärkerschaltung, mit der sich, wie gesagt, eine Angleichung der Betriebswiderstände in beiden Verstärkungsrichtungen erzielen läßt, ggf. noch ein Anpassungsvierpol VP erforderlich sein kann, da die Betriebswiderstände im allgemeinen nicht von vornherein gleich dem Last- bzw. Quellenwiderstand sein werden.

Will man zu größeren Leistungen übergehen und zugleich das genannte eine Halbleiterverstärkerelement $T_V$ gemäß Fig. 1 mit einem handelsüblichen Kleinsignal-Feldeffekttransistor realisieren, so kann es auch zweckmäßig sein, für das genannte eine Halbleiterverstärkerelement ($T_V$) und das genannte weitere Halbleiterverstärkerelement ($T_L$) getrennte Anpassungsvierpole vorzusehen, die ggf. auch abgeschaltet werden können.

Ein mögliches Ausführungsbeispiel ist in Fig. 2 angedeutet. In der hier dargestellten Wechselspannungsverstärkerschaltung gemäß der Erfindung ist das eine, allein bei Eingangsverstärkerbetrieb vom Anschluß A zum Anschluß B wirksame Halbleiterverstärkerelement $T_V$ wiederum durch einen Feldeffekttransistor gebildet, wobei in dem den Feldeffekttransistor $T_V$ enthaltenden einen Schaltungszweig ein eigener Anpassungsvierpol $VP_V$ vorgesehen ist. Das andere, nur bei Verstärkerbetrieb vom Anschluß B zum Anschluß A wirksame Halbleiterverstärkerelement $T_L$ ist (entsprechend Fig. 1a) durch einen bipolaren Transistor gebildet, wobei auch in dem diesen bipolaren Transistor $T_L$ enthaltenden Schaltungszweig ein eigener Anpassungsvierpol $VP_L$ vorgesehen ist. Zur Abriegelung des Schaltungszweiges kann eine PIN-Diode D vorgesehen sein ; zwischen der Eingangs-/Ausgangsklemme A bzw. dem Verzweigungspunkt a der beiden Schaltungszweige und dem Anpassungsvierpol $VP_L$ kann eine Wellenleitung $l_L$ solcher Länge vorgesehen sein, daß bei gesperrtem Transistor $T_L$ — wobei dann die Wellenleitung $l_L$ praktisch mit einem reinen Blindwiderstand abgeschlossen ist — die Wellenleitung $l_L$ am Verzweigungspunkt a eine offene Leitung (Leerlauf) darstellt.

Eine entsprechende Wellenleitung $l_L$ liegt zwischen dem Verzweigungspunkt a und dem im anderen Leitungszweig liegenden Anpassungsvierpol $VP_V$, wie dies in Fig. 2 angedeutet ist. Um bei höheren Leistungen diesen sozusagen den Kleinsignalzweig bildenden Leitungszweig zu schützen, ist zweckmäßigerweise, wie dies ebenfalls in Fig. 2 angedeutet ist, ein PIN-Diodenschalter S in der zum Eingang des Anpassungsvierpols $VP_V$ führenden Leitung vorgesehen.

Ein weiteres Ausführungsbeispiel einer Wechselspannungsverstärkerschaltung gemäß der Erfindung ist in Fig. 3 dargestellt. Auch in dieser Schaltungsanordnung enthalten der einen Feldeffekttransistor $T_V$ als das genannte eine Halbleiterverstärkerelement enthaltende, gewissermaßen den Kleinsignalzweig bildende eine Leitungszweig und der einen bipolaren Transistor $T_L$ als das genannte andere Halbleiterverstärkerelement enthaltende, gewissermaßen den Leistungszweig bildende andere Leitungszweig jeweils einen eigenen Anpassungsvierpol $VP_V$ bzw. $VP_L$. Die Zusammenschaltung der die beiden Halbleiterverstärkerelemente $T_V$, $T_L$ enthaltenden Parallelzweige geschieht hier mit Hilfe eines Diplexers, d.h. durch eine Frequenzweiche ; eine solche Zusammenschaltung der beiden Parallelzweige empfiehlt sich insbesondere dann, wenn die Frequenzen der bei Eingangsverstärkerbetrieb zu verarbeitenden Signale sich wesentlich von den Frequenzen der bei Leistungsverstärkerbetrieb zu verarbeitenden Signale unterscheiden.

**Ansprüche**

1. Wechselspannungsverstärkerschaltung mit mehreren in Gate-(Basis-)Schaltung betriebenen Halbleiterverstärkerelementen ($T_V$, $T_L$), insbesondere Feldeffekttransistoren, deren Verstärkungsrichtung (A-B, B-A) jeweils erst durch das Anlegen von bestimmten Betriebsspannungen festgelegt und durch Umschalten dieser Betriebsspannungen ($U_1$, $U_2$) umschaltbar ist, dadurch gekennzeichnet, daß wenigstens zwei Halbleiterverstärkerelemente ($T_V$, $T_L$) parallel zueinander vorgesehen sind, von denen ein symmetrisch aufgebautes Halbleiterverstärkerelement ($T_V$) sowohl bei Betrieb der Wechselspannungsverstärkerschaltung als Kleinsignalverstärker in der einen Verstärkungsrichtung (A-B) als auch bei Betrieb der Wechselspannungsverstärkerschaltung als Leistungsverstärker in der anderen Verstärkungsrichtung (B-A) wirksam ist, während das (die) weitere(n) Halbleiterverstärkerelement(e) ($T_L$) bei Umschaltung der Verstärkungsrichtung für die Leistungsverstärkung zu- bzw. in Gegenrichtung für die Kleinsignalverstärkung abschaltbar ist (sind).

2. Wechselspannungsverstärkerschal tung nach Anspruch 1, dadurch gekennzeichnet, daß das eine Halbleiterverstärkerelement ($T_V$) durch einen Feldeffekttransistor, das (die) weitere(n) Halbleiterverstärkerelement(e) ($T_L$) dagegen durch (jeweils) einen bipolaren Transistor gebildet ist (sind).

3. Wechselspannungsverstärkerschaltung nach Anspruch 1, dadurch gekennzeichnet, daß die beiden Feldeffekttransistoren ($T_V$, $T_L$) auf einem Chip integriert sind.

4. Wechselspannungsverstärkerschaltung nach Anspruch 1 oder 2, dadurch gekennzeichnet, daß die beiden Halbleiterverstärkerelemente ($T_V$, $T_L$) in einem gemeinsamen Gehäuse zusammengefaßt sind.

5. Wechselspannungsverstärkerschaltung nach einem der vorhergehenden Ansprüche, dadurch gekennzeichnet, daß das (die) weitere(n) Halbleiterverstärkerelement(e) ($T_L$) mit weiteren Halbleiterverstärkerelementen zu einem mehrstufigen Verstärker verbunden sind.

6. Wechselspannungsverstärkerschal tung nach einem der vorhergehenden Ansprüche, dadurch gekennzeichnet, daß die die wenigstens zwei parallel zueinander vorgesehenen Halbleiterverstärkerelemente ($T_V$, $T_L$) enthaltenden Schaltungszweige mit einem gemeinsamen Anpassungsvierpol (VP) verbunden sind.

7. Wechselspannungsverstärkerschal tung nach einem der vorhergehenden Ansprüche, dadurch gekennzeichnet, daß die die wenigstens zwei parallel zueinander vorgesehenen Halbleiterverstärkerelemente ($T_V$, $T_L$) enthaltenden Schaltungszweige jeweils einen eigenen Anpassungsvierpol ($VP_V$, $VP_L$) enthalten.

8. Wechselspannungsverstärkerschaltung nach Anspruch 7, dadurch gekennzeichnet, daß ein solcher Schaltungszweig eine Wellenleitung ($l_V$, $l_L$) enthält, die bei gesperrtem Schaltungszweig am Verbindungspunkt beider Schaltungszweige eine im Leerlauf betriebene offene Leitung bildet.

9. Wechselspannungsverstärkerschaltung nach Anspruch 7, dadurch gekennzeichnet, daß die beiden Schaltungszweige durch eine Frequenzweiche (Diplexer) zusammengeführt sind.

**Claims**

1. An alternating-voltage amplifier stage comprising a plurality of semiconductor amplifier elements ($T_V$, $T_L$), in particular field effect transistors, which are each operated in common base or gate circuit configurations, the amplification direction (A-B, B-A) of which is determined by the specific applied operating voltage and can be changed by switching these operating voltages ($U_1$, $U_2$) characterised in that at least two semiconductor amplifier elements ($T_V$, $T_L$) are arranged parallel to one another, of which one symmetrically constructed semiconductor amplifier element ($T_V$) is effective both when the alternating-voltage amplifier stage is operated as small signal amplifier in one amplification direction (A-B) and when the alternating-voltage amplifier stage is operated as a power amplifier in the other amplification direction (B-A), whereas when the amplification direction is changed the other semiconductor amplifier element(s) ($T_L$) can be switched on for power amplification or switched off in the opposite direction for small signal amplification as the case may be.

2. An alternating-voltage amplifier stage as claimed in Claim 1, characterised in that one semiconductor amplifier element ($T_V$) is formed by a field effect transistor, whereas the other semiconductor amplifier element(s) ($T_L$) is/are (respectively) formed by a bipolar transistor.

3. An alternating-voltage amplifier stage as claimed in Claim 1, characterised in that two field effect transistors ($T_V$, $T_L$) are integrated on a chip.

4. An alternating-voltage amplifier stage as claimed in Claim 1 or 2, characterised in that the two semiconductor amplifier elements ($T_V$, $T_L$) are combined in a common housing.

5. An alternating-voltage amplifier stage as claimed in one of the preceding Claims, characterised in that the further semiconductor amplifier element(s) ($T_L$) is/are connected to further semiconductor amplifier elements to form a multi-stage amplifier.

6. An alternating-voltage amplifier stage as claimed in one of the preceding Claims, characterised in that the circuit branches comprising at least two semiconductor amplifier elements ($T_V$, $T_L$), which are arranged parallel to one another, are connected to a common matching four-pole (VP).

7. An alternating-voltage amplifier stage as claimed in one of the preceding Claims, characterised in that the circuit branches comprising at least two semiconductor amplifier elements ($T_V$, $T_L$), which are arranged parallel to one another, respectively contain a separate matching four-pole ($VP_V$, $VP_L$).

8. An alternating-voltage amplifier stage as claimed in Claim 7, characterised in that a circuit branch of this type comprises a wave guide ($l_V$, $l_L$) which, when the circuit branch is blocked, forms an open line section presenting no load at the junction point of the two circuit branches.

9. An alternating-voltage amplifier stage as claimed in Claim 7, characterised in that the two circuit branches are brought together by a frequency filter.

## Revendications

1. Circuit amplificateur de tension alternative à plusieurs éléments amplificateurs à semiconducteurs montés en porte (base) comme ($T_V$, $T_L$), en particulier des transistors à effet de champ, dont le sens d'amplification (A-B, B-A) n'est commutable que par l'application de tensions de fonctionnement déterminée et par la commutation de ces tension de fonctionnement ($U_1$, $U_2$), caractérisé par le fait qu'au moins deux éléments amplificateurs à semiconducteurs ($T_V$, $T_L$) sont prévus en parallèle entre eux, parmi lesquels un élément amplificateur à semiconducteurs ($T_V$) constitué de façon symétrique est actif aussi bien lors du fonctionnement du circuit amplificateur de tension alternative comme amplificateur de petit signal dans l'un (A-B) des sens d'amplification que lors du fonctionnement du circuit amplificateur de tension alternative comme amplificateur de puissance dans l'autre sens d'amplification (B-A), alors que l'autre (ou les autres) élément(s) amplificateur à semiconducteurs ($T_L$) est (sont), lors de la commutation du sens d'amplification, susceptible(s) d'être branché(s) pour l'amplification de puissance et débranché(s) dans le sens opposé pour l'amplification du petit signal.

2. Circuit amplificateur de tension alternative selon la revendication 1, caractérisé par le fait que l'un ($T_V$) des éléments amplificateurs à semiconducteurs est formé par un transistor à effet de champ, alors que l'autre (ou les autres) élément(s) amplificateur à semiconducteurs ($T_L$) est par contre constitué (respectivement) par un transistor bipolaire.

3. Circuit amplificateur de tension alternative selon la revendication 1, caractérisé par le fait que les deux transistors à effet de champ ($T_V$, $T_L$) sont intégrés sur une puce.

4. Circuit amplificateur de tension alternative selon la revendication 1 ou 2, caractérisé par le fait que les deux éléments amplificateurs à semiconducteurs ($T_V$, $T_L$) sont rassemblés dans un boîtier commun.

5. Circuit amplificateur de tension alternative selon l'une des revendications précédentes, caractérisé par le fait que l'autre (ou les autres) élément(s) amplificateurs à semiconducteurs ($T_L$) sont reliés avec d'autres éléments amplificateurs à semiconducteurs pour former un amplificateur à plusieurs étages.

6. Circuit amplificateur de tension alternative selon l'une des revendications précédentes, caractérisé par le fait que les branches du circuit qui comportent au moins deux éléments amplificateurs à semiconducteurs ($T_V$, $T_L$) montés en parallèle entre eux, sont reliés à un quadripole d'adaptation commun (VP).

7. Circuit amplificateur de tension alternative selon l'une des revendications précédentes, caractérisé par le fait que les branches du circuit qui contiennent au moins deux éléments amplificateurs à semiconducteurs ($T_V$, $T_L$) montés en parallèle entre eux, comportent chacune un quadripole d'adaptation ($VP_V$, $VP_L$) qui lui est propre.

8. Circuit amplificateur de tension alternative selon la revendication 7, caractérisé par le fait qu'une telle branche de montage contient un guide d'onde ($l_V$, $l_L$) qui forme, lorsque la branche du circuit est bloquée, au niveau du point de liaison des deux branches du circuit, un conducteur ouvert fonctionnant à vide.

9. Circuit amplificateur de tension alternative selon la revendication 7, caractérisé par le fait que les deux branches du circuit sont reliées par une bifurcation sélective (diplexeur).

FIG 1

FIG 1a

FIG 2

FIG 3